# EUROPEAN PATENT APPLICATION

(11) **EP 2 945 185 A1**
(43) Date of publication of application: **18.11.2015**
(21) Application number: 13191827.8
(22) Date of filing: 06.11.2013
(51) Int. Cl.: H01L 21/20

(54) **Epitaxial wafers avoiding edge melt-back-etching and method for fabricating the same**

(71) Applicant: Azzurro Semiconductors AG, 01237 Dresden (DE)
(72) Inventor: Chitnis, Ashay, 01309 Dresden (DE); Tan, Wei-Sin, 01309 Dresden (DE); Pinos, Andrea, 01257 Dresden (IT)

(57) **Abstract**

An epitaxial wafer 100, comprising a silicon substrate having a principal surface with a center region 110 and an edge region near an outer circumferential line of the principal surface, and a polycrystalline or amorphous edge-mask layer 120, which is made of a material suitable for growth of group-III-nitride material thereon and which is deposited directly and only on the edge region of the principal surface, such that the center region 110 and the edge-mask layer 120 together form a growth substrate for a group-III-nitride buffer layer 130 structure conformally deposited thereon.

## Description

The present invention relates to an epitaxial wafer and to a fabrication method for such an epitaxial wafer.

Group-III-nitride semiconductors are widely used in light-emitting devices and power devices. The use of silicon as a growth substrate for the group-III-nitride material has become more common only in recent years, because it requires sophisticated layer designs for stress management.

One issue to be resolved for achieving high-quality group-III-nitride material on silicon wafers is the reduction or complete avoidance of edge melt-back etching (EMB). The inherent difficulties in controlling strain at wafer edges results in cracking at these areas and subsequent formation of melt-back. Melt-back etching is an undesired destructive chemical reaction between Gallium and the silicon wafer that takes place when a gallium source contacts the silicon of the wafer at high temperatures, resulting in particle contamination on the wafer. The presence of melt-back causes significant problems for photolithography and wafer bonding processes.

To solve this issue, US 2013/0087807 proposes an epitaxial growth substrate comprising a silicon wafer and a buffer layer of group-III-nitride material, which is single-crystalline in the center portion of the wafer and polycrystalline in an edge region. In order to achieve a polycrystalline buffer growth in the edge region, the principal surface of the silicon wafer is roughened in the edge region.

According to a first aspect of the present invention, an epitaxial wafer comprises
- a silicon substrate having a principal surface with a center region and an edge region near an outer circumferential line of the principal surface, and
- a polycrystalline or amorphous edge-mask layer, which is made of a material suitable for growth of group-III-nitride material thereon, and which is deposited directly and only on the edge region of the principal surface such that the center region and the edge-mask layer together form a growth substrate for a group-III-nitride buffer layer structure conformally deposited thereon.

According to a second aspect of the present invention, an epitaxial wafer comprises
- a silicon substrate having a principal surface with a center region and an edge region near an outer circumferential line of the principal surface, and
- a polycrystalline or amorphous edge-mask layer, which is made of a material suitable for growth of group-III-nitride material thereon and which is deposited directly on the edge region of the principal surface and forms a patterned regular grid that covers sections of the center region of the principal surface of the silicon substrate, such that remaining uncovered principal surface of the silicon substrate and the edged mask layer together form a growth substrate for a group-III-nitride buffer layer structure conformally deposited thereon.

In other words, in an epitaxial wafer according to the second aspect of the invention, the edge-mask layer is not only present in the edge region, but also in form of a grid in the center region.

The term "edge-mask layer" is therefore used in several embodiments for layers, which extend only in the edge region of the wafer. However, as in the structure of the second aspect of the invention, the term is not to be interpreted as excluding coverage of a center region of the substrate in all embodiments of the invention. Some embodiments with an edge-mask layer that additionally comprises a grid as an additional masking in parts of the center region will be presented in more detail further below.

The epitaxial wafers according to the first and second aspect has edge-mask layers, which in comparison with prior-art solutions form an additional barrier between Ga and Si and thus are more effective in avoiding melt-back etching. In comparison with solutions known from the prior art, the edge-mask layer of the epitaxial wafers of the first and second aspects allows achieving a reduced processing expenditure in the manufacturing of the epitaxial wafer, by for instance allowing the use of deposition processes for the fabrication of the edge-mask layers..

In a third aspect of the present invention, an epitaxial wafer comprises
- a silicon substrate having a principal surface with a center region and an edge region near an outer circumferential line of the principal surface, and
- an edge mask, which comprises amorphous silicon formed from surface sections of the silicon substrate and which is arranged only in the edge region of the principal surface, such that the center region and the edge mask together form a growth substrate for a group-III-nitride buffer layer structure conformally deposited thereon.

The epitaxial wafers of all three aspects are based on the recognition that the damaging process of melt-back etching starts with cracking of the epilayers deposited on the wafer due to developing stress during the growth process that cannot sufficiently compensated in the wafer edge region. As a consequence, gallium reacts with the silicon wafer, which results melt-back etching.

The epitaxial wafers according to the first to third aspect of the present invention show at least a reduced edge melt-back etching, and in some embodiments none at all.

An epitaxial wafer in the present specification is a processed wafer comprising a layer structure on a silicon substrate and suitable for high-quality epitaxial growth of group-III-nitride layers thereon.

In the following, embodiments of the epitaxial wafers of the present invention will be described.

The silicon substrate is the growth substrate for the group-III-nitride buffer layer structure conformally deposited thereon. In preferred embodiments, it is an industry-standard silicon wafer, as used in the industry for instance in the fabrication of CMOS-technology based integrated circuits.

A coverage of the edge region of the silicon substrate with the edge-mask layer or the edge mask, respectively, extends laterally is in some embodiments within less than 5 millimeter from the outer circumferential line of the principal surface. Preferably, the lateral extension is between 0.5 millimeter and 5 millimeter. The mentioned extension refers to a direction perpendicular to the point of measurement and to the plane of the principal surface assumed to be perfectly flat.

The group-III-nitride buffer layer structure typically has a sublayer structure in order to enable the growth of a crack-free, low-defect-density layer structure, preferably also resulting in a virtually vanishing wafer bow on the epitaxial wafer. In particular, such a buffer layer structure serves for adequately compensating stress in the layer structure, which is caused during the fabrication process by differences in lattice constants and coefficients of thermal expansion of the substrate and of the group-III-nitride materials grown on the substrate. Suitable buffer layer structures including also nucleation layers are known in the art. In the present specification in one embodiment a single layer is also considered as the group-III-nitride buffer layer structure. Suitable materials used in the buffer layer structure are for example GaN, AlGaN, InGaN, InAlGaN, but also other group-III-nitrides can be used.

The epitaxial wafer according to embodiments of the first or second aspect of the invention comprises a polycrystalline or amorphous edge-mask layer. As an example, suitable materials for the layers includes poly-Silicon, Molybdenum, SiC or Al₂O₃ but the layer is not limited to only these materials. These materials are able to induce a growth of group-III-nitride buffer layers with a higher amount of crystallographic defects than in sections of a group-III-nitride buffer layer structure, which are grown directly on a silicon substrate.

An additional micro-structuring of the edge-mask layer improves the inducement of a group-III-nitride buffer layer growth with high amounts of crystallographic defects, in some embodiments even a polycrystalline growth. In some embodiment, therefore, the edge-mask layer has an internal lateral microstructure of openings, whether periodic or irregular. In one such embodiment, the material of the edge-mask layer is a porous material, for instance fabricated by using self-assembled growth of nanoscale or microscale crystallites within the desired lateral extension of the edge-mask layer. In another exemplary embodiment of this kind, the edge-mask layer is patterned internally, i.e., has a openings within its lateral extension that are fabricated by suitable processing. The micro-structuring thus implies lateral substructures on a microscopic scale that are formed within the edge-mask layer, while the patterned regular grid is in comparison structured on a macroscopic scale.

In embodiments of the epitaxial wafer according to the third aspect of the invention, the regions of amorphous silicon formed from the substrate material also form an edge mask layer that has a patterned regular grid. As well as in the embodiment of the epitaxial wafers according to the first and second aspect of the invention, the additional structuring improves the inducement of group-III-nitride buffer layer structure growth with high amounts of crystallographic defects.

The present specification uses the term "crystallographic defect" to indicate defects or irregularities in the crystal structure, such as, dislocations, grain boundaries, vacancy defects and interstitial defects, or line defects or planar defects. The present specification clearly distinguishes these crystallographic defects from macroscopic defects, for exam-ple cracks or melt-back etching defects. The term "higher amount of crystallographic defects" in the present specification applies to embodiments having single-crystals with a higher crystallographic defect density as well as to embodiments having polycrystalline or amorphous materials, wherein amorphous materials are considered as having the highest amount of crystallographic defects, followed, in the direction of lower density of crystallographic defects, by polycrystalline materials and single-crystalline materials. The lowest defect density or concentration is present in a perfect single-crystal.

In further embodiments of the epitaxial wafers of the first, second or third aspect of the invention, the group-III-nitride buffer layer structure comprises a strain-relief section of the group-III-nitride buffer layer, which is grown on the edge-mask layer or on the edge-mask region and which has a higher amount of crystallographic defects than a high-quality section of the group-III-nitride buffer layer structure, which is grown on the center region of the principal surface of the silicon substrate, which is not covered by the edge-mask layer. The group-III-nitride buffer layer structure herein shows a higher amount of crystallographic defects in the strain-relief section, which leads to a reduced overall stress in the buffer layer structure and thus avoids cracks in the high-quality section of the group-III-nitride buffer layer structure.

In other words, the higher amount of crystallographic defects in those regions of the group-III-nitride buffer layer structure, which are defined by the lateral extension of the edge-mask layer on which they are grown, stress in the group-III-nitride layer structure as a whole is reduced and other regions of the group-III-nitride buffer layer structure, which are grown with a lower amount of crystallographic defects, i.e., the high-quality sections, are further enhanced.

These embodiments of the epitaxial wafers according to the first to third aspect of the present invention thus induce the growth of the high-quality sections of the group-III-nitride buffer layer structure on the principal surface of the silicon substrate, and of strain-relief sections of the group-III-nitride buffer layer structure, which are grown on the edge-mask layer. The strain-relief sections may be termed sacrificial sections, because their purpose is to reduce the stress in the layer structure and to protect the high-quality sections from cracking and subsequent melt-back. However, the strain-relief sections are not suitable for device fabrication in many application cases, and therefore will be discarded during later processing steps in a device fabrication process.

In preferred embodiments of the epitaxial wafer according to the first, second or third aspect of the present invention, the group-III-nitride buffer layer structure is free of cracks and melt-back etching, and even more preferred free of any macroscopic defects. With such a group-III-nitride buffer layer structure, high-quality semiconductor devices, such as LEDs or transistors, can be achieved from growth in the high-quality sections.

According to a fourth aspect of the present invention, the invention relates to a method for forming an epitaxial wafer, wherein the method comprises
- providing a silicon substrate having a principal surface with a center region and an edge 20 region near an outer circumferential line of the principal surface, and
- fabricating a polycrystalline or amorphous edge-mask, which is made of a material suitable for growth of group-III-nitride material thereon, only on the edge region of the principal surface,
- conformally depositing a group-III-nitride buffer layer structure on the center region and the edge-mask, which together form a growth substrate for the group-III-nitride buffer layer structure.

The method shares the advantages of the epitaxial wafers of the first to third aspect of the invention.

In one embodiment of the method, which leads to an epitaxial wafer according to the first aspect of the invention, fabricating the polycrystalline or amorphous edge-mask comprises depositing an edge-mask layer directly and only on the edge region of the principal surface.

In a second embodiment of the method, which leads to an epitaxial wafer according to the second aspect of the present invention, fabricating the polycrystalline or amorphous edge mask comprises depositing an edge-mask layer directly on the edge region of the principal surface and a patterned regular grid that covers a section of the center region of the principal surface of the silicon substrate such that parts of the principal surface of the silicon substrate remain uncovered.

In one embodiment of the method, depositing the edge-mask layer comprises depositing a self-assembled porous edge-mask layer material. In an alternative embodiment of the method, depositing the edge-mask layer comprises depositing a regularly patterned material.

In a further embodiment of the method, which leads to an epitaxial wafer according to the third aspect of the present invention, fabricating the polycrystalline or amorphous edge mask comprises forming amorphous silicon from surface sections of the silicon substrate only in the edge region of the principal surface.

For the fabrication of the edge mask common lithography technologies are used in one embodiment to shape the edge mask. Positive photolithography masks can be used as well as negative photolithography masks in order to shape the edge-mask layer. For edge-mask layers as well as for an edge mask of amorphous silicon stencil lithography is used in other embodiments of the invention. Stencil lithography is advantageous because the stencil can be removed easily without chemical, mechanical or temperature treatment of the wafer.

Further embodiments of the invention will be described hereinafter with reference to the drawings, in which in form of schematic drawings:
Fig. 1 shows an embodiment of an epitaxial wafer according to the first aspect of the invention, wherein Fig. 1a shows a top view of an epitaxial wafer and Fig. 1b shows a part of the edge region in the sectional view;
Fig. 2 shows a second embodiment of an epitaxial wafer according to the first aspect of the invention, wherein Fig. 2a shows a sectional view of the edge region of the epitaxial wafer and Fig. 2b and Fig. 2c show top views of two embodiments of the edge-mask layer;
Fig. 3 shows an embodiment of an epitaxial wafer according to the second aspect of the invention;
Fig. 4 shows an embodiment of an epitaxial wafer according to third aspect of the invention;
Fig. 5 shows a second embodiment of an epitaxial wafer according the third aspect of the invention, wherein Fig. 5a shows a sectional view of an edge region of the epitaxial wafer and Fig. 5b shows a top view of the edge mask in the edge region;
Fig. 6 shows an embodiment of a method for forming an epitaxial wafer according to the fourth aspect of the invention as a sequence of cross sectional views of the edge region of the epitaxial wafer;
Fig. 7 shows another embodiment of a method according to the fourth aspect of the invention as a sequence of cross sectional views of the edge region of the epitaxial wafer.

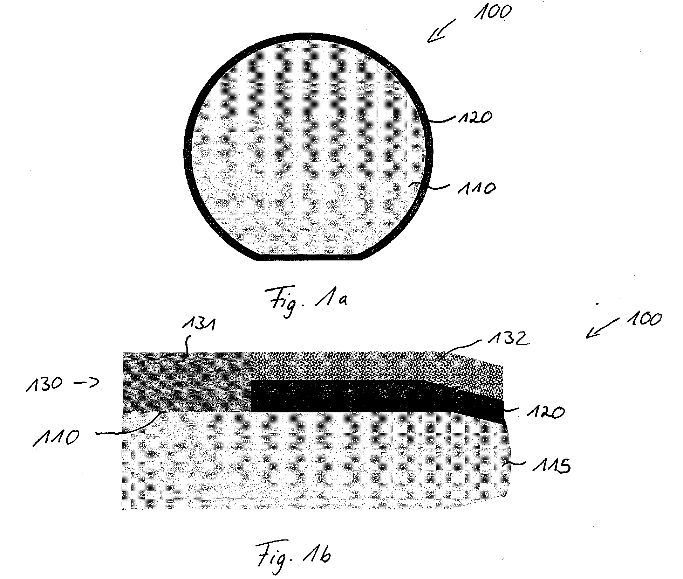

Fig. 1 shows an embodiment of an epitaxial wafer 100 according to the first aspect of the invention. Fig. 1a shows the epitaxial wafer in a top view. In this view, a group-III-nitride buffer layer structure, which is shown in Fig. 1b is not yet deposited. Thus, Fig. 1a shows a center region 110 of the principle surface of the silicon substrate in the center region of the epitaxial wafer 100 and an edge-mask layer 120 on the edge region of the principle surface of the silicon substrate near an outer circumferential line of the principle surface.

Fig. 1b shows a sectional view of an edge part of the epitaxial wafer 100 with the silicon substrate 115 on which in the edge region the edge-mask layer 120 is deposited. A group-III-nitride buffer layer 130 is deposited on the center region 110 of the principle surface of the silicon substrate as well as on the edge-mask layer 120. The group-III-nitride buffer layer structure 130 comprises in the shown embodiment a plurality of single group-III-nitride buffer layers. In other embodiments the group-III-nitride buffer layer structure can also comprise a single layer. The group-III-nitride buffer layer structure 130 comprises two section, a high quality section 131, which is grown on the center region 110 of the principle surface of the silicon substrate 115 and a strain-relief section 132, which is grown on the edge-mask layer 120. The strain-relief section 132 herein has a higher amount of crystallographic defects than the high quality section 131 of the group-III-nitride buffer layer structure 130. The strain-relief section with its higher amount of crystallographic defects inhibits the building of cracks in the high quality section by reducing the strain in the group-III-nitride buffer layer structure. The strain-relief section 132 can be considered as a sacrificial region, which is later sacrificed in order to improve the quality of the high quality region 131. With the shown epitaxial wafer the quality of semiconductor devices build up by using the epitaxial wafer can be improved and the reject rate is reduced.

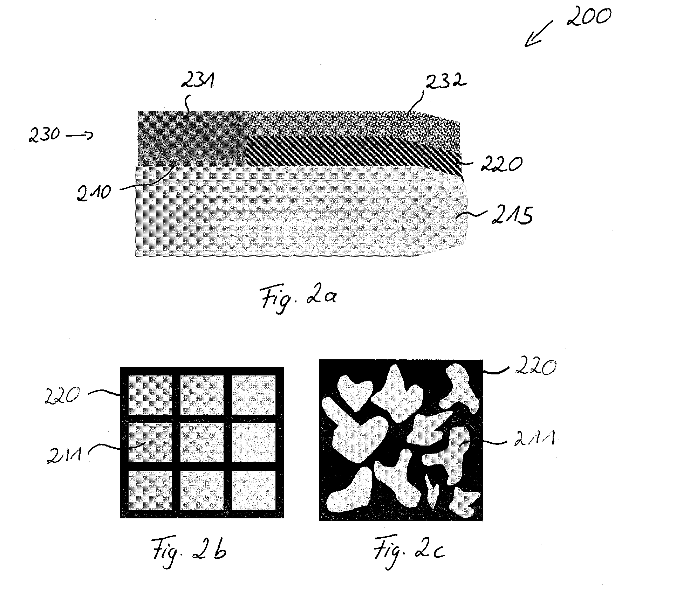

Fig. 2 shows a second embodiment of an epitaxial wafer 200 according to the first aspect of the invention. Fig. 2a shows an edge part of the epitaxial wafer 200 in the sectional view. The second embodiment of the epitaxial wafer 200 differs from the first embodiment, shown in Fig. 1, by the structuring of the edge-mask layer 220. In the second embodiment, the edge-mask layer 220 is micro-structured. The micro-structuring of the edge-mask layer 220 can be a regular pattern, as shown in Fig. 2b or an irregular pattern, i. e. build up by a self-assembled porous material, as shown in Fig. 2c. The Fig. 2b and 2c hereby show top view on a part of an uncovered edge-mask layer in two different embodiments.

In Fig. 2b the edge-mask layer 220 shows regular openings, through which parts of the principle surface 211 of the silicon substrate 315 are exposed, the material of the edge-mask layer 220 in this embodiment is a polycrystalline material. In other embodiments the edge-mask layer 220 comprises amorphous material. In Fig. 2c the edge-mask layer 220 is built from a self-assembled porous material, which shows irregular openings, through which parts of the principle surface 211 are exposed.

The additional micro-structuring, if regular or irregular, further improves the epitaxial wafer while inducing a higher amount of crystallographic defects in the strain-relief section 232 of the group-III-nitride buffer layer 230, grown on top of the edge-mask layer 220. In a limit case, the strain-relief section 232 is a polycrystalline section. In other embodiment of the invention, the strain-relief section 232 is single crystalline, but has a higher defect density than the high quality section 231 of the group-III-nitride buffer layer. The high quality section of the group-III-nitride buffer layer is in all embodiments of the invention single crystalline.

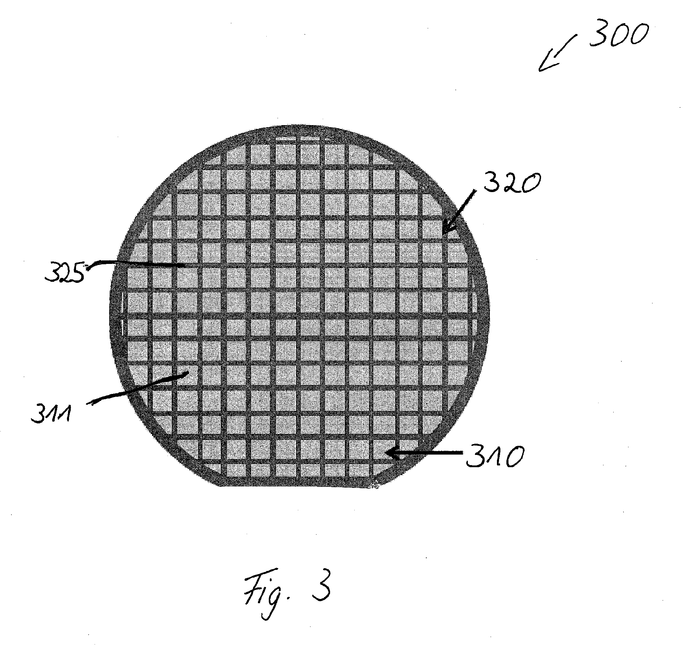

Fig. 3 shows an embodiment of an epitaxial wafer 300 according to a second aspect of the invention in a top view. The epitaxial wafer 300 according to the second aspect of the invention comprises an edge-mask layer not only in the edge region of the principle surface of the silicon substrate, but also as a patterned regular grid 325 that covers section of the center region 310 of the principle surface of the silicon substrate, such that remaining uncovered principle surface 311 of the silicon substrate and the edge-mask layer 220 comprising the grid 325 together form a growth substrate for a group-III-nitride buffer layer structure conformally deposited thereon. The patterned regular grid 325 additionally improves the strain-relief in the buffer layer structure grown on top of it. The patterned regular grid 325 is in one embodiment formed of a material, which is additionally micro-structured. This means, that the material can be either self-assembled porous or regularly patterned, wherein the patterning has a smaller substructure size than the grid itself.

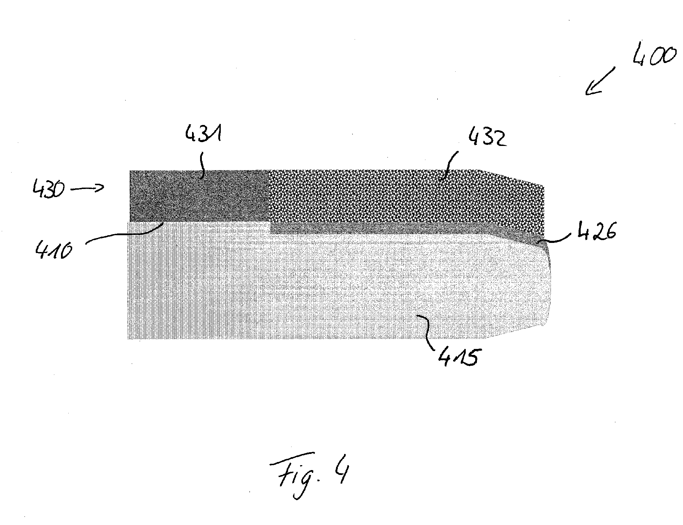

Fig. 4 shows an embodiment of an epitaxial wafer 400 according to the third aspect of the invention. In distinction to the first and second aspect of the invention, this embodiment of an epitaxial wafer 400 does not comprise a deposited edge-mask layer covering the edge region of the silicon substrate 415, but instead an edge mask 426, which comprises amorphous silicon formed from surface sections of the silicon substrate. The amorphous layer also induce polycrystalline growth or the growth of single crystalline strain-relief section 432 of group-III-nitride buffer layer structure on top of it, which has a higher amount of crystallographic defect than a high quality part 431 of the group-III-nitride buffer layer structure, which is grown directly on the center region 410 of principle surface of the silicon substrate.

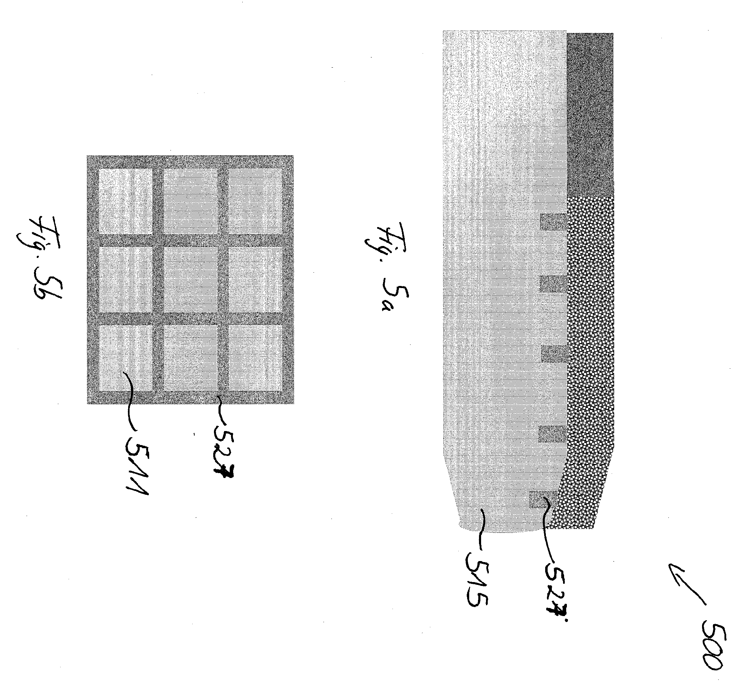

Fig. 5 shows a second embodiment of an epitaxial wafer 500 according the third aspect of the invention. In contrast to the embodiment, shown in Fig. 4, the embodiment of Fig. 5, which is shown in a sectional view in Fig. 5a and in a top view on the edge mask 527 in Fig. 5b, comprises an edge mask 527 in form of a regular pattern, herein a grid. The edge mask is in this embodiment build up in the form of a regular pattern in the principle surface 211 of the silicon substrate 215, wherein a grid is formed by amorphous silicon in the silicon substrate.

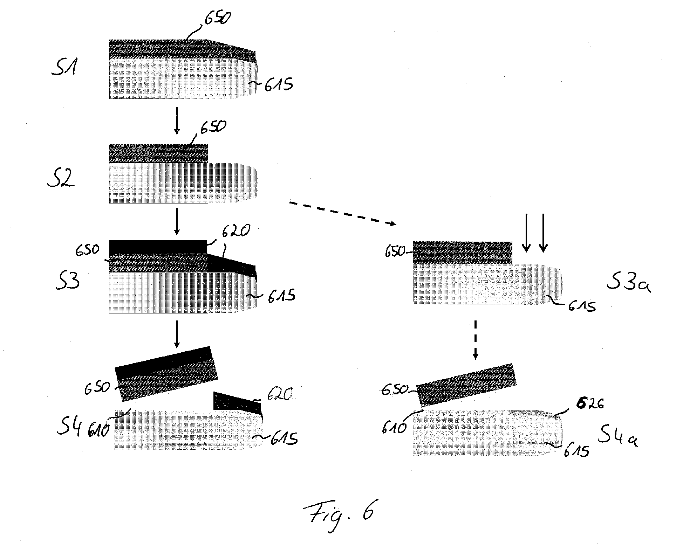

Fig. 6 shows an embodiment of a method for forming an epitaxial wafer as a sequence of sectional views of an edge region of the wafer. As a first step, which is not shown in the drawings, a silicon substrate 610 is provided having a principle surface with a center region and an edge region near an outer circumferential line of the principle surface. In step S1 a temporary fabrication mask layer 650 is deposited on the whole principle surface of the silicon substrate 615. In step S2 the temporary fabrication mask layer is patterned. As materials for the temporary fabrication mask layer, i. e. photoresists or SiO₂ are advantageous. The patterning can i. e. be made by etching. In step S3 the edge-mask layer 620 is deposited on the whole substrate. Thus, the edge-mask layer in this step covers the temporary fabrication mask 650 as well as the exposed parts of the principle surface of the substrate, which is in the shown embodiment the edge region of the substrate. In step S4 the temporary fabrication mask 650 as well as the edge-mask layer covering the temporary fabrication mask are removed and the center region 610 of the principle surface of the silicon substrate is exposed. In the further steps, which are not shown in the drawings, the group-III-nitride buffer layer structure is deposited on the epitaxial wafer 600. For forming an epitaxial wafer according to the third aspect of the invention an alternative step S3A is performed instead of step S3. In step S3A, the exposed the silicon substrate is treated with plasma bombardment with plasma in order to form amorphous silicon of the exposed parts of the surface of the silicon substrate. Consequently, in step S4A only the temporary fabrication mask 650 is removed.

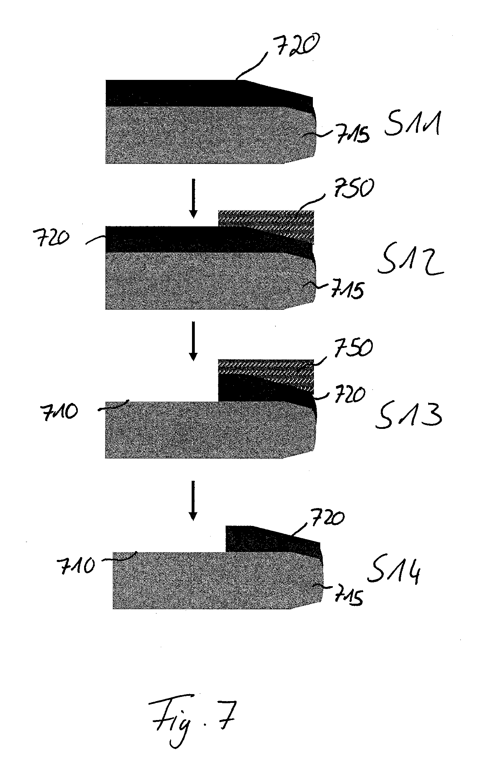

Fig. 7 shows an alternative embodiment of a method for forming an epitaxial wafer 700 according to the first or the second aspect of the invention. In contrast to the method shown in Fig. 6, the process in Fig. 7 uses a positive mask, which means instead of covering sections of the principle surface of the silicon substrate, which will be exposed in the last fabrication step, in the process of Fig. 7 the mask covers the remaining part of the edge-mask layer during the process of exposing the principle surface. After providing a silicon substrate 715 with a principle surface with a center region and an edge region near an outer circumferential line of the principle surface in step S11, the edge-mask layer 720 is deposited on the whole principle surface of the silicon substrate. In step S12, a temporary fabrication mask is deposited on the edge region of the epitaxial wafer. In step S13, the uncovered part of the edge-mask layer is removed and the center region 710 of the principle surface is exposed. In step S14 the temporary fabrication mask 750 is removed and subsequent deposition of a group-III-nitride buffer layer is performed in further steps, not shown herein.

### Reference list

- 100, 200, 300, 400, 500, 600, 700: epitaxial wafer
- 110, 210, 410, 510, 710: center region
- 115, 215, 415, 515, 615: silicon substrate
- 120, 220, 320, 620, 720: edge-mask layer
- 130, 230: group-III-nitride buffer layer
- 131, 231, 431, 531: high quality section
- 132, 232, 432, 532: strain-relief section
- 211, 311: uncovered principle surface
- 325: patterned regular grid
- 426: edge mask
- 650, 750: fabrication mask layer
- S1, S2, S3, S3A, S4A, S11, S12, S13, S14: step

## Claims

1. An epitaxial wafer (100), comprising
- a silicon substrate (115) having a principal surface with a center region (110) and an edge region near an outer circumferential line of the principal surface, and
- a polycrystalline or amorphous edge-mask layer (120), which is made of a material suitable for growth of group-III-nitride material thereon and which is deposited directly and only on the edge region of the principal surface, such that the center region (110) and the edge-mask layer (120) together form a growth substrate for a group-III-nitride buffer layer (130) structure conformally deposited thereon.

2. An epitaxial wafer (100), comprising
- a silicon substrate (115) having a principal surface with a center region (110) and an edge region near an outer circumferential line of the principal surface, and
- a polycrystalline or amorphous edge-mask layer (120), which is made of a material suitable for growth of group-III-nitride material thereon and which is deposited directly on the edge region of the principal surface and forms a patterned regular grid that covers sections of the center region (110) of the principal surface of the silicon substrate (115), such that remaining uncovered principal surface of the silicon substrate and the edge-mask layer (120) together form a growth substrate for a group-III-nitride buffer layer (130) structure conformally deposited thereon.

3. The epitaxial wafer (100) according to at least one of the claims 1 or 2, wherein the edge-mask layer (120) is a layer of poly-Silicon, Al, Ti, Hf, Mo, Zn, SiGe, SiC, HfN, TiN, ZnO or Al₂O₃.

4. The epitaxial wafer (100) according to at least one of the claims 1 to 3, wherein the edge-mask layer (120) is micro-structured.

5. An epitaxial wafer (400), comprising
- a silicon substrate (415) having a principal surface with a center region (410) and an edge region near an outer circumferential line of the principal surface, and
- an edge mask (426), which comprises amorphous silicon formed from surface sections of the silicon substrate (415) and which is arranged only in the edge region of the principal surface, such that the center region (410) and the edge mask together form a growth substrate for a group-III-nitride buffer layer (430) structure conformally deposited thereon.

6. The epitaxial wafer (400) according to claim 5, wherein the amorphous silicon is arranged in the form of a patterned regular grid.

7. The epitaxial wafer (100) according to at least one of the claims 1 to 6, wherein a strain-relief section of the group-III-nitride buffer layer (130) structure, which is grown on the edge-mask layer (120) or on the edge mask (426) region has a higher amount of crystallographic defects than a high-quality section of the group-III-nitride buffer layer (130) structure, which is grown on the center region of the principal surface of the silicon substrate, which is not covered with the edge-mask layer (120).

8. The epitaxial wafer (100) according to at least one of the claims 1 to 7, wherein the group-III-nitride buffer layer (130) structure is free of macroscopic defects, preferably free of cracks and melt-back etching.

9. The epitaxial wafer (100) according to at least one of the claims 7 or 8, wherein the higher amount of crystallographic defects means that the edge section of the buffer layer structure is polycrystalline.

10. The epitaxial wafer (100) according to at least one of the preceding claims, wherein a lateral extension of the edge-mask layer in the edge region of the silicon substrate measured from the outer circumferential line of the principal surface in a direction perpendicular to the outer circumferential line is between 0.2 millimeter and 10 millimeter.

11. A method for forming an epitaxial wafer (100), comprising
- providing a silicon substrate (115) having a principal surface with a center region (210) and an edge region near an outer circumferential line of the principal surface, and
- fabricating a polycrystalline or amorphous edge mask, which is made of a material suitable for growth of group-III-nitride material thereon, only on the edge region of the principal surface,
- conformally depositing a group-III-nitride buffer layer (130) structure on the center region and the edge-mask, which together form a growth substrate for the group-III-nitride buffer layer (130) structure.

12. The method according to claim 11, wherein fabricating the polycrystalline or amorphous edge mask comprises depositing an edge-mask layer (120) directly and only on the edge region of the principal surface.

13. The method according to claim 11, wherein fabricating the polycrystalline or amorphous edge mask comprises depositing an edge-mask layer (120) directly on the edge region of the principal surface and a patterned regular grid that covers sections of the center region of the principal surface of the silicon substrate, such that parts of the principal surface of the silicon substrate remain uncovered.

14. The method according to claim 11, wherein fabricating the polycrystalline or amorphous edge mask (426) comprises forming amorphous silicon from surface sections of the silicon substrate (115) only in the edge region of the principal surface.

15. The method according at least one of the claims 12 to 13, wherein fabricating the polycrystalline or amorphous edge mask comprises depositing the edge-mask layer (120) in form of a self-assembled porous material or in form of a regularly patterned material.
